# EUROPEAN PATENT APPLICATION

(11) **EP 1 990 442 A1**
(43) Date of publication of application: **12.11.2008**
(21) Application number: 08005416.6
(22) Date of filing: 27.03.2007
(51) Int. Cl.: C23C 14/04, B05C 1/12

(54) **Device for vacuum deposition of a coating on a continuous material, with liquid applicator**

(62) Divisional of application: 07425180.2
(71) Applicant: Galileo Vacuum Systems S.p.A., 59100 Prato (IT)
(72) Inventor: Pagani, Angelo, 40138 Bologna (IT)
(74) Representative: Mannucci, Michele

(57) **Abstract**

The system for vacuum deposition comprises: an evacuable chamber; in said chamber, a feed path of the web material in a vacuum environment; along the feed path, a process roller (19) around which said web material is guided; associated with the process roller, at least one vaporization source (13) of at least one material to form said coating. Upstream of the source there is disposed an applicator unit (51) for applying a liquid product to the web material according to a pre-established pattern. The applicator unit comprises a printing cylinder (53), cooperating with a distributor cylinder (55), and a source (57) of said liquid product. The printing cylinder (53) comprises at least one substantially continuous circumferential projection, which generates a continuous contact with the web material fed around the process roller (19) or with said process roller during treatment of the web material.

## Description

### Technical field

The present invention relates to a system or device for metallization of a continuous substrate, such as paper, a polymer film or another material. More generally, the invention relates to a system or device for vacuum deposition of a coating on a substrate.

More specifically, the present invention relates to a device of the aforesaid type which has means to create metal-free or deposition-free areas of various shape, for example to obtain a specific pattern or also technical-functional characteristics of the finished product, such as strips of nonconductive material, for the production of capacitors.

### State of the art

To perform vacuum deposition of layers of metal materials on substrates, such as polymer films, paper or the like, vacuum metallization systems are commonly employed, in which a reel of substrate to be coated is inserted in a chamber and in which the substrate is subsequently unwound and fed around a process roller to be rewound in a reel of treated product. Positioned under the process roller are vaporization sources from which vapors of metal (or another material) are generated, which then condenses in the form of a thin layer of coating on the corresponding face of the film or other substrate.

The vaporization sources are, for example, composed of boats made of highly conductive sintered material resistant to temperature, which are heated by Joule effect through the passage of an electric current. The metal to be vaporized is fed to said boats. In continuous feed systems said metal is fed in the form of wires of aluminum or another suitable material, unwound from respective reels with a feed speed corresponding to the hourly quantity of metal to be vaporized.

Similar systems or devices are also used to form vacuum deposition of non-metal materials on a substrate, such as a film or the like. Vacuum depositions differing from actual metallization can consist in deposits of metal oxides or other compounds to create a barrier effect on a polymer film for use in packaging or on other substrates.

Systems for this type of vacuum deposition processes are described in WO-A-03/038142; EP-A-0082001; US-A-4,962,725; US-A-5,350,598. Particular forms of boats or vaporization sources heated by Joule effect suitable for application in these systems are described in EP-A-1408135. Besides the sources heated by Joule effect other types of source are known in the art, such as induction heated soruces, or sources with electron gun-sputtering systems or the like. The type of source varies according to the nature of the material with which deposition is performed and the nature of the substrate, or other aspects of the products and/or of the process adopted for the manufacturing thereof.

For some specific applications, for example to produce a metallized film to be used in the production of capacitors, or a metallized film for packaging, and for other technical and functional uses, it is necessary to create metal-free patterned areas. For this purpose, US-A-5,223,038 describes, by way of example, a system of nozzles that spray an oil onto the substrate to be metallized to prevent the metal from adhering in the areas that are to remain metal-free. Consequently, when the film is fed around the process roller in front of the vaporization source, the areas wet with oil remain metal-free. The quantity of oil applied is extremely small and normally evaporates from the film without the need to provide specific removal means. A further vacuum deposition device of this type is described in US-A-6,106,627.

A system for the same purpose, in which the oil is applied to a longitudinal covering strip, to produce longitudinal metal-free bands, is described in US-A-4,478,878. US-A-5,652,022 describes a vacuum metallization device in which metal-free strips are obtained by masking formed with a continuous flexible member which covers the portion of film to remain metal-free. Both these systems are only suitable to produce longitudinally extending metal-free bands or strips.

US-A-4,832,983 and US-A-5136462 describe a system in which oil is transferred to the film to be metallized by a pair of rotating rollers, one to distribute the oil on the film and the other to collect the oil from a source. The latter can be composed in turn of a take-up roller and of a storage tank, or of a series of nozzles or orifices through which the oil flows to be distributed on the surface of the roller.

US-A-6,048,402 describes a device for distributing oil on a film to be metallized, composed of a transverse conduit provided with a plurality of nozzles, from which oil evaporates to condense on the film which is fed in front of the nozzles. A similar system is described in US-A-5,942,283.

EP-A-0.447.550 describes a system of rollers to apply oil to a film to be metallized. The applicator roller can have a raised pattern of varied configuration according to the shape of the metal-free areas to be obtained.

An improved system for applying an oil or other liquid product to define metal-free areas is described in EP-A-1.693.481.

The present invention is not limited to a particular type of material (for example, metal as coating material and plastic film as substrate) or deposition technique (for example, using sources heated by Joule effect) but can be used in a wide range of different applications.

### Objects and summary of the invention

An object of an embodiment of the present invention is to provide a metallization device or system that allows patterned areas or in any case metal-free areas to be produced on a continuous substrate, which supplies a product of improved quality.

According to a first aspect, the invention provides for a system for vacuum deposition of a coating on a web material, comprising: a vacuum chamber; in said chamber, a feed path of the web material in a vacuum environment; along said feed path, a process roller around which said web material is guided; associated with said process roller, at least one vaporization source of at least a first material to form said coating; upstream of said at least one source, along the feed path of the web material, an applicator unit for applying a liquid product to the web material according to a pre-established pattern, said applicator unit comprising a printing cylinder, cooperating with a distributor cylinder of said liquid product, and a source of said liquid product. To obtain more regular operation of the system, the printing cylinder comprises at least one or preferably at least two circumferential, i.e. annular, substantially continuous projections, which generate a substantially continuous contact with the web material fed around the process roller, or directly with the process roller, during treatment of the web material. In this manner the printing cylinder rests continuously against the process roller, if necessary with interposition of the film or other web substrate fed around the process roller. It must be understood that the annular or circumferential projection or projections can be located within the operating width of the machine or device, i.e. in contact with the web material treated. In this case they can also act as elements that apply the oil or other liquid to the substrate. Nonetheless, one, some or all the annular projections can be outside the treatment area, i.e. in end portions of the printing cylinder. In this case the projection or projections that are not in contact with the web material will be directly in contact with the process roller. They will not be used to apply the liquid to the substrate or web material, but will nonetheless have the function of making contact between the process roller and the printing cylinder continuous and even. In both cases, intermediate annular or non-annular projections can be provided on the printing cylinder, which come into contact with the web material or substrate to apply the oil or other liquid according to a pattern. The substrate on which deposition takes place is usually very thin, and therefore it is not necessary to provide for a difference in height between projections that are in direct contact with the process rollers and projections that are in contact with the web material fed around the process roller.

In one embodiment, the applicator unit applies a liquid product with adhesion-preventing properties, for example an oil. Nonetheless, the present invention is not limited to this, albeit particularly advantageous, application. The liquid applied by the applicator unit can for example be a polymerizable or crosslinkable material, with which to form a protective layer or the like. Depending on the type of liquid applied various crosslinking systems can be used, with different energy sources to perform, stimulate, accelerate or promote crosslinking or curing, or any other desired chemical or physical reaction on the material applied to the substrate.

In one embodiment, the source of said liquid product is an evaporator, and the evaporated liquid condenses on the distributor cylinder. In a modified embodiment, the applicator comprises an immersion distributor cylinder, which takes up the liquid from a tank in which said cylinder is partly immersed.

Preferably the printing cylinder comprises two substantially continuous circumferential projections, for example advantageously disposed in proximity to the ends of the printing cylinder, in contact with the web material fed around the process roller, directly with the process roller, or partly in contact with the process roller and partly with the substrate. According to the axial length of the printing cylinder, there can be provided intermediate annular or circumferential projections. At the level of the circumferential or annular projections, the film or other web material or continuous substrate treated in the system will have longitudinal strips to which the liquid has been applied and which consequently (for example, if the liquid is an oil or other adhesion-preventing product) will be metal free.

In vacuum metallization systems the process roller is normally cooled. In some systems it is cooled by a refrigerating circuit in which a refrigerating fluid circulates. Cooling is necessary to remove the heat generated by the vaporization source, whether this is a source heated by Joule effect or another source.

When the system comprises an applicator unit, for example using an evaporation source or an oil, the distributor cylinder located over the source heats up. When the applicator unit is idle, i.e. the printing cylinder is not in contact with the web material fed around the process roller, the two printing and applicator cylinders reach an equilibrium temperature, normally even several tens of degrees centigrade above the temperature of the process roller. For example, the process roller can be kept at -15°C, while the applicator roller (in the absence of contact between the printing cylinder and the process roller) can even reach a temperature of over 90°C.

When the printing cylinder comes into contact with the web material fed around the process roller, the temperature of the printing cylinder decreases from the initial temperature approximately the same as the temperature of the applicator cylinder (also called anilox cylinder or roller) to a lower temperature due to the heat yielded, through the web material, to the process roller. This variation in temperature influences the quality of the finished product, as the change in temperature of the cylinders causes a change in the condensation conditions of the oil or other adhesion-preventing liquid, used to prevent the aluminum or other metal applied by vaporization from adhering to the web substrate. Moreover, there are also drawbacks deriving from the dimensional variations of the mechanical members determined by the variation in temperature.

According to a different aspect, an object of the invention is to prevent or alleviate these drawbacks.

According to one embodiment, at least one of said printing cylinder and said distributor cylinder comprises a temperature control device. Preferably, both said cylinders have a temperature control device. In one embodiment, the system performs thermostating of one or the other or both cylinders, maintaining them within a determined temperature interval. Temperature control can stabilize the degree of filling of the cells of the anilox cylinder or distributor cylinder, i.e. of the cavities provided on the surface of this cylinder and inside which the liquid, for example adhesion-preventing oil, collects. Similarly, temperature control stabilizes the wettability of the printing cylinder; one or the other and preferably both the aforesaid effects, in combination, improve the quality of the finished product.

The printing cylinder and/or distributor or anilox cylinder can be heated to remain at a controlled temperature. According to a preferred embodiment, nonetheless, one or the other or both cylinders are cooled. This prevents dispersion of further heat towards the process roller, which in any case must be cooled to prevent the high input of heat due to the vaporization source or sources from damaging the plastic film or other substrate fed around this process roller.

Cooling, heating or more generically thermostating or temperature regulation can be obtained with a water cooling circuit that serves the rest of the system, or by means of the refrigerating circuit that cools the process roller, or by means of a dedicated refrigerating circuit. The type of cooling circuit can be chosen also as a function of the operating temperature to be maintained for the various rollers or cylinders.

Temperature control of the applicator unit and of one or more of the cylinders thereof facilitates its use also to apply liquids differing from oil or other adhesion-preventing products. In fact, temperature control allows the applicator unit to be used to distribute liquids with different characteristics in terms of viscosity, specific weight, vapor tension, or other physical parameters. Temperature control also allows control of the condensation of the liquid, for example oil, on the anilox cylinder.

This last possibility allows advantageous use of the applicator system or unit, which can be combined with a treatment station, disposed downstream of said applicator unit, along the path of the web material around the process roller. The treatment station can comprise a device that applies energy to the liquid, for example a UV generator, an electron gun, a plasma system or the like. The energy can be used to cause or facilitate crosslinking or polymerization of the liquid applied. Two or more treatment stations of this type could also be provided, disposed upstream of the metal vaporization source, downstream of said source or both upstream and downstream thereof. In an embodiment, the vaporization source of the metal or other material to form the vacuum deposition can be omitted.

The thermostating system for the applicator unit can also be used with printing rollers or cylinders without annular projections.

In an embodiment, the distributor or anilox cylinder and the printing cylinder can be motorized each with its own separate motor. In a modified embodiment, the distributor or anilox cylinder can be motorized with a separate motor of its own, while the printing cylinder can be mounted idle and made to rotate through contact with the distributor cylinder and/or process roller. The latter is usually provided with a main motor of its own.

Nonetheless, in a preferred embodiment, the distributor cylinder is operated in rotation through a mechanical transmission that takes its motion from the process roller, without the need to use a separate motor for the distributor cylinder. In this case the printing cylinder can be equipped with a separate motor of its own. In a preferred embodiment, the printing cylinder is instead mounted idle and made to rotate through contact with the distributor cylinder and/or the process roller, both motorized through one common motor and through said mechanical transmission. In a modified embodiment the mechanical transmission that transmits motion from the motor of the process roller to the distributor cylinder can also provide the motion for the printing cylinder.

Transmission of motion from the motor of the process roller to the distributor cylinder in combination with the idle printing cylinder constitutes a particularly advantageous solution, as in this manner a device is obtained which is particularly simple from the viewpoint of construction, calibration, handling and maintenance and which is also particularly inexpensive. This embodiment also allows printing cylinders of different diameter to be used alternatively without difficulty and without the need for lengthy calibration operations. The presence of the annular projections that guarantee continuous contact between process roller (or material fed thereon) and printing cylinder, and between the latter and the distributor cylinder, allows more efficient driving in rotation of the printing cylinder through friction.

To guarantee the constancy of the transmission ratio and prevent relative slipping, the mechanical transmission between process roller and distributor cylinder can take place through a toothed belt, a series of gears or gear train, a chain, drive shafts and idler wheels, or other positive transmission systems.

It must be understood that the possibility of thermostating the roller or rollers of the applicator unit can also be provided in a system without annular projections on the roller or printing cylinder, and conversely the printing cylinder with the annular projections can be used with or without the thermostating system. Moreover, although the mechanical transmission described above is advantageous if combined with the presence of annular or circumferential projections on the printing cylinder, it can also be adopted for different applicator unit systems, even without these annular or circumferential projections, and also with or without temperature control systems of the rollers.

Further advantageous characteristics and embodiments of the invention are indicated hereunder and in the appended claims.

### Brief description of the drawings

The invention will now be better understood by following the description and accompanying drawing, which shows a non-limiting practical exemplification of said finding. In the drawing:
Figure 1 shows a schematic cross section of the metallization system or device in which the invention is incorporated;
Figure 2 shows an enlarged detail of the system to apply oil to the substrate to be metallized; and

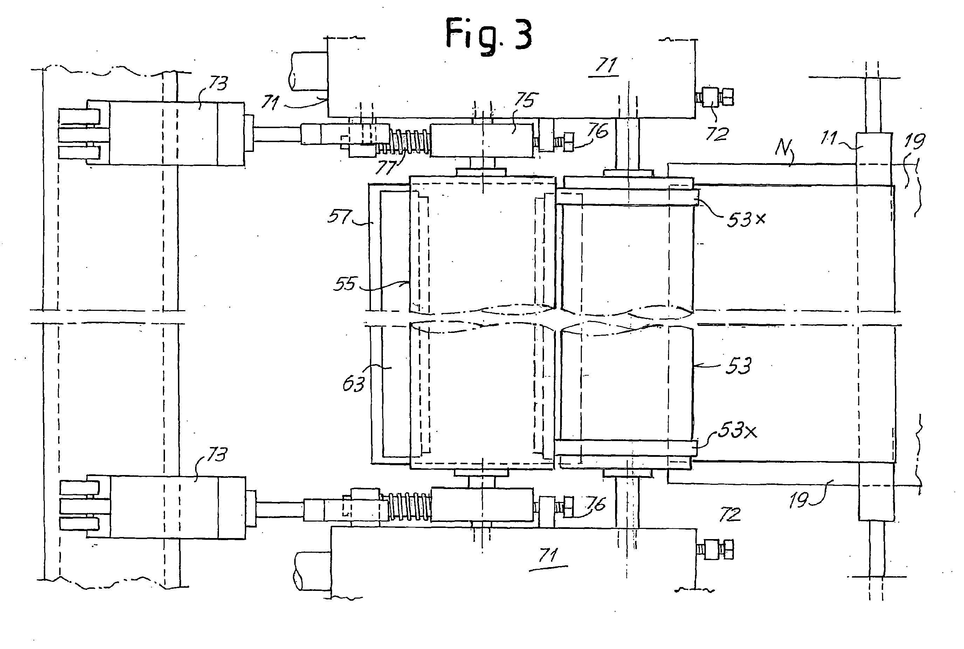

Figure 3 shows a plan view of the unit or system to apply oil to the substrate to be metallized;
Figure 4 shows a longitudinal section of the printing cylinder;
Figure 5 shows a side view of a kinematic diagram of a possible embodiment of the motorization of the applicator unit; and
Figure 6 shows a schematic and partial plan view of the transmission in Figure 5.

### Detailed description of a preferred embodiment of the invention

In the description that follows reference is made to a system of the type illustrated and described in EP-A-1.693.481 and which, besides the characteristics of the invention, also has further elements relative to the system for adjusting the cylinders of the applicator unit. Nonetheless, it must be understood that the concepts underlying the present invention can also be applied in systems of different types.

Moreover, according to some embodiments, the product applied can be an oil, or another preferably adhesion-preventing liquid material, as will be described in the example of embodiment set forth below. Nonetheless, in other embodiments of the invention it can be used to distribute other materials or products, such as a substantially liquid product, which is polymerizable or crosslinkable to form a protective layer.

In the description below specific reference will be made to a vacuum metallization device or system. Nonetheless, it must be understood that the invention can also be applied in systems for deposition of materials other than metal, such as oxides or mixtures of oxides to create vacuum depositions that improve the barrier effect.

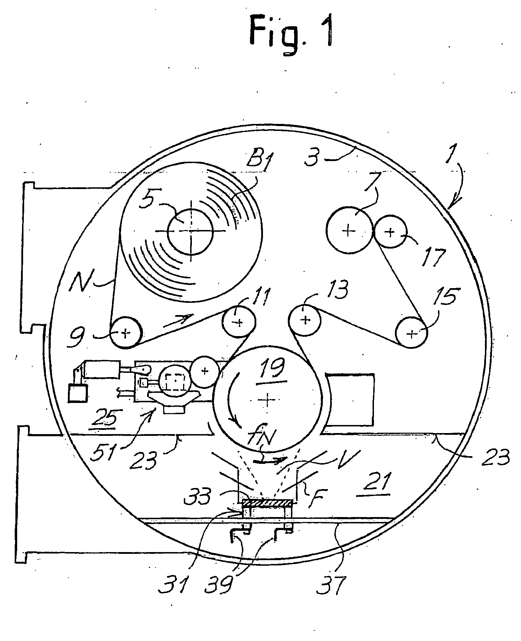

Figure 1 schematically shows, in a section along a vertical plane, the inside of a vacuum metallization system.

It comprises a container or main evacuable chamber 3, housing two supports 5 and 7 for the reels of the web substrate N to be metallized, for example a polymer film, a strip of paper or the like. Arranged on the support 5 is a reel B1 of substrate still to be treated which is fed along a feed path defined by drive rollers 9, 11, 13 15, 17. Positioned on the support 7 is a second reel being formed, on which the substrate is wound after metallization.

Positioned between roller 11 and roller 13 is a process roller 19 with a larger diameter which projects partly inside a chamber 21 separated, by a wall 23, from the chamber above 25 in which the supports 5 and 7 for the reels of substrate are arranged. The chamber 21 is kept under a higher degree of vacuum than the chamber 25. Systems also exist in which there is no separating wall 23 and no division into chambers 21 and 25. In this case the reel being unwound, the rewinding reel, the path of the substrate N, the process roller 19 and the vaporization sources are all in the same chamber. Systems also exist in which a third chamber, known as a guard chamber, is provided adjacent to the process roller.

The web substrate N unwound from the reel B1 and fed around the process roller 19 is gradually rewound to form a reel of metallized substrate on the support 7. During unwinding, while the web substrate N is being fed around the process roller 19, a metal which has been vaporized by a series of sources 31 located in the chamber 21, under the process roller 19, is deposited on the surface thereof which is not in contact with the process roller 19. The vaporized material, schematically indicated with V, is emitted from the sources 31, which are adjacent to each other according to an alignment orthogonal to the direction FN of feed of the substrate, i.e. orthogonal to the plane of the figure. Therefore, only one source is visible in Figure 1.

The structure of the metallization system can vary and the embodiment represented in Figure 1 is only a schematic example of a possible system in which the invention can be implemented.

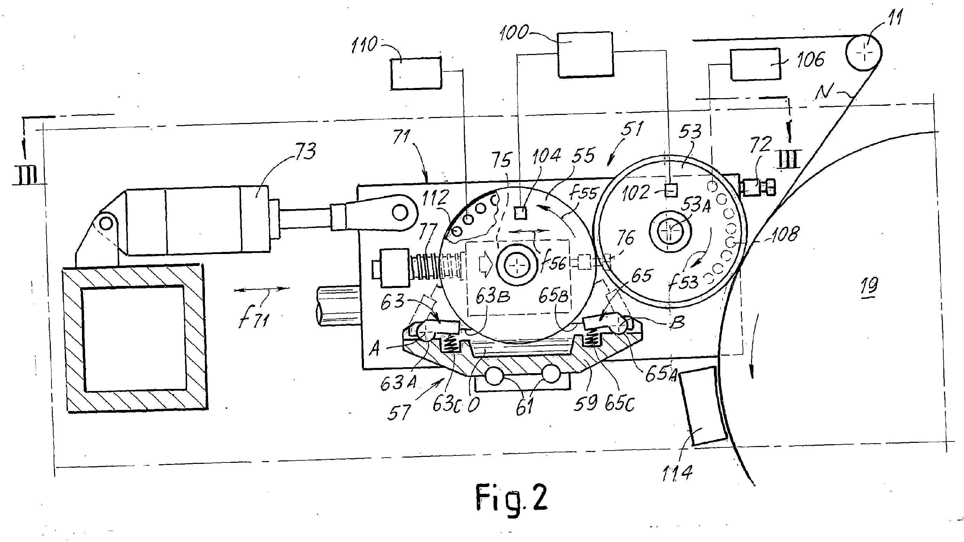

An applicator unit 51 is positioned on the process roller 19, on the feed side of the substrate N fed from the reel B1 and on which vacuum deposition must be performed, to apply, according to a suitable pattern, a thin film of oil on the surface of the substrate N before it passes in front of the metallization sources 31. The configuration of the applicator unit 51 is described in greater detail hereunder with specific reference to the diagram in Figure 2.

The unit 51 comprises a first printing cylinder 53, which has on its surface a raised pattern composed of projections with a conformation and distribution corresponding to the pattern to be produced on the substrate N by metal-free areas. The printing cylinder 53 rotates according to the arrow f53 to have a zero relative velocity with respect to the substrate N fed around the process roller 19. The cylindrical surface of the printing cylinder 53 can be produced at least in part in an elastically yielding material.

The printing cylinder 53 is tangent to an anilox cylinder 55 rotating according to arrow f55, preferably at a peripheral speed equal to the speed of the printing cylinder 53. This cylinder 55 forms a distributor cylinder of the oil on the raised pattern of the printing cylinder 53. The surface of the anilox cylinder 55 is engraved, for example with laser engraving, to create thereon a plurality of small cells (screen), inside which an oil distributed by a distributor unit 57 described in detail hereunder and forming the oil source, is retained. The oil that is retained in the cells of the anilox cylinder 55 is then transferred to the front surfaces of the projections or protuberances of the printing cylinder 53.

The distribution unit 57 in substance has a reservoir or container 59 containing oil O optionally heated by a system of resistors 61. Two doctor blades, indicated generically with 63 and 65, close the space between the aperture of the reservoir 59 and the cylindrical surface of the anilox cylinder 55. Each of the two doctor blades 63, 65 comprises, in the example shown, a substantially rigid profile 63A, 65A oscillating about an axis of oscillation A or B and extending substantially for the entire longitudinal extension of the anilox cylinder 55 and of the reservoir or container 59. Each of these profiles 63A, 63B is provided with a flexible sheet 63B, 65B which, during operation of the device, is in contact with the cylindrical side surface of the anilox cylinder 55.

The profiles 63A, 65A are stressed by compression springs 63C, 65C so as to press the sheets 63B, 65B against the cylindrical surface of the cylinder 55. The compression springs 63C, 65C can be adjustable to adjust the pressure of the doctor blades on the anilox cylinder.

The members described hereinbefore, namely the distribution unit or source 57, the anilox or distributor cylinder 55 and the printing cylinder 53, are supported by side panels 71. These side panels can be adjusted to be closer to or farther from the cylindrical surface of the process roller 19 and consequently the substrate N fed around said roller, or can be thrust with a controlled force against said roller. Advantageously, adjustment of thrust and/or of the position can take place separately for the two side panels, i.e. for the two ends of the printing cylinder 53 and of the anilox or distributor cylinder 55.

The movement to adjust or to move the side panels 71 towards or away from the process roller 19 is indicated with f71. The printing cylinder 53 is supported on the side panels on an axis 53A fixed with respect to said side panels 71, so that a movement according to f71 to adjust or move the side panels 71 towards the process roller means that the printing cylinder 53 is moved closer to the process roller 19 to a greater or lesser extent. Alternatively, the reciprocal position between the process roller 19 and the printing cylinder 53 can remain the same and equal to the thickness of the web material or substrate N to be treated, but the thrust exerted by the cylinder 53 on the process roller 19, and consequently the contact force with the substrate N, can be suitably adjusted or controlled.

According to an advantageous embodiment, a respective actuator 73 is associated with each of the two side panels 71, in this example represented by a hydraulic or pneumatic piston-cylinder actuator. Alternatively, a mechanical or electrical actuator can be used, such as an electronically controlled electric motor with a mechanical transmission such as a worm screw. Further, in another embodiment a simple elastic thrust member can be provided.

The arrangement of two actuators associated with the respective two side panels allows separate adjustment of the force with which each of the two side panels 71 is thrust towards the process roller 19. This makes it possible to obtain uniform contact pressure between the printing cylinder 53 and the web material or substrate N across the entire width of the latter. Alternatively, or in combination, the actuators 73 can be produced to control the position of the printing cylinder with respect to the process roller, adjusting the two ends of said cylinder separately.

A possible and advantageous solution can comprise an electric actuator with electronic control of the position and optionally control of the thrust for each side panel.

In an advantageous embodiment of the invention, an adjustable stop 72 is associated with each side panel 71, so that the position of each side panel can be adjusted separately from the other to allow optimal positioning of the printing cylinder with respect to the process roller 19, the operating position being maintained through the thrust of the actuators 73 against the adjustable stops 72.

When the two adjustable stops 72 are provided, the actuators 73 can operate by taking the respective side panels in stable contact against these stops, which will define the reciprocal adjustable position of the printing cylinder with respect to the process roller 19. Alternatively, or in combination, the stops can be elastic. In this case the actuators can thrust the side panels 71 against the stops 72, which give sufficient elasticity to allow the system to adapt to any variations in the operating conditions, without undesirable stresses arising.

In practice, various solutions can be used which comprise, individually or in combination:
➢ position-controlled actuators, for example with position encoders,
➢ thrust-controlled actuators, for example with load cells or other thrust sensors,
➢ rigid adjustable stops, in which case the actuators preferably have an elasticity of their own, they are for example pneumatic actuators,
➢ elastic or at least moderately elastic adjustable stops.

It would also be possible to use only the actuators 73 with thrust and/or position control systems, without the stops, for example through suitable selection of the type of actuator and of the optional adjustment ring.

The anilox cylinder 55 is supported in turn at the ends thereof by supporting blocks 75 mounted on guides (not shown) integral with the side panels 71. A thrust member 77 on each of the two side panels 71 separately pushes the corresponding end of the anilox cylinder 55 towards the printing cylinder 53, obtaining in this case as well a substantially uniform distribution of pressure (along the axial extension of the cylinders 55, 53) between said cylinders. Alternatively, according to a preferred embodiment, an adjustable stop 76 for the respective supporting block 75 is arranged on each side panel 71, so that the position of the anilox cylinder 55 with respect to the printing cylinder 53 can be adjusted optimally.

The thrust member 77 can be - as indicated by way of example and preferably - an elastic member, but can also be an actuator, for example of the hydraulic, pneumatic, electric or mechanical type.

Also in the case of the thrust members 77 and the adjustable stops 76 (just as in the case of the actuators 73 and the stops 72) it would be possible to use actuators of various types or simple elastic thrust members, in combination with adjustable rigid or elastic stops, to adjust the position and/or thrust of the anilox cylinder 55 with respect to the printing cylinder 53, with separate adjustment at the two ends of the cylinder 55.

The distributor 57 is preferably integral with the supporting blocks 75 so as to move with them together with the anilox distributor cylinder 55. Alternatively to the representation in the drawing, in which the anilox cylinder 55 is immersed in the oil O contained in the reservoir 59, the anilox cylinder 55 could be positioned above the free surface of the oil O and the latter could be made to evaporate from the reservoir and condense on the surface of the anilox cylinder 55.

With the expedients described above optimal adjustment and extremely regular operation of the applicator device 51 are obtained, allowing metal-free areas with high definition, precision and repeatability of the pattern to be produced.

In at least some of the possible configurations of the applicator unit, the force with which one or other of the cylinders is thrust and/or the reciprocal position can be adjusted with the metallization chamber closed using an external control and also, if necessary, during the deposition process. In this way further advantages are obtained with regard to function and quality of the final product.

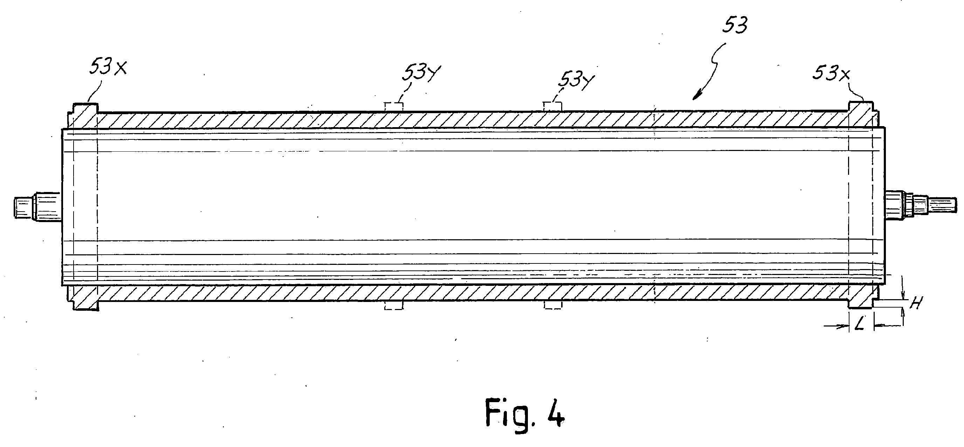

In one embodiment (Figure 4) the printing cylinder 53 has, near the axial ends thereof, two annular or circumferential projections 53X, of width L (measured in the direction of the axis of the printing cylinder 53) and height H (measured in radial direction). For example, the dimension L can be of a few millimeters to a few centimeters, and the height H can be of a thickness corresponding to the thickness of any other projections (not shown) of the printing cylinder with which the oil or other adhesion-preventing liquid is applied to the film N. If the projections are placed outside the useful operating area, i.e. not in contact with the film or other web material or substrate N, their height can in any case be substantially the same, considering the extremely reduced thickness of the web material N. Otherwise, they can be slightly higher than the projections of the printing cylinder 53 in contact with the film N.

When the device or applicator unit 51 is operating the annular or circumferential projections 53X are in contact with the film or other web material N, and rest on the underlying surface of the process roll 19. In this way continuous and even contact is obtained, without vibrations or jumping between the cylinder 53 and the roller 19, also with the material N interposed, or between the cylinder 53 and the cylinder 55. Operation is more regular also in the case in which the pattern of the printing cylinder, which is located between the two projections 53X extends discontinuously, which gives rise to a cyclical variation of the overall contact surface between printing cylinder 53 and material N.

If the printing cylinder 53 is particularly long and/or in the case of particular printing patterns, it may be useful or necessary to provide one or more intermediate annular or circumferential projections 53Y.

In one embodiment, a thermostating system can be applied to one or the other of the cylinders 53 and 55, to control and maintain the temperature at a controlled value or in any case within an interval of tolerance. In Figure 2, this is schematically indicated by the presence of a control unit 100, for example connected to two temperature sensors 102 and 104 associated with the printing cylinder 53 and with the distributor cylinder 55. In one embodiment, a cooling system, indicated schematically with 106, is associated with the printing cylinder 53, for example comprising a duct or an assembly of ducts 108 for circulation of a refrigerating fluid inside said printing cylinder 53. In one embodiment, a different cooling system 110 is associated with the distributor cylinder 55, with which a system 112 for circulation of a refrigerating fluid is combined. The two circuits can be replaced by a single refrigeration system, or by a heating system, although - in view of the temperatures involved - a cooling or refrigeration system is more advantageous.

The cooling system or systems with the thermostat unit allow the two cylinders 53 and 55 to be maintained at a temperature within a controlled interval, notwithstanding the input of thermal energy by the source 57 and the removal of heat by the process roller 19, by conduction through the film or other web material N.

It would also be possible or necessary to provide a cooling system for the distributor cylinder 55, which is subject to direct heating, and a heating system for the printing cylinder 53, which is subject to cooling. Nonetheless, as one of the critical aspects of the process roller 19 is to remove an adequate quantity of heat to prevent damage to the web material N, cooling of the printing cylinder 53 appears preferably from the viewpoint of energy and quality of the material produced.

Control of the temperature of the cylinder or cylinders 53 and 55 allows a liquid to be applied that can, for example, be treated with an energy application in a station indicated schematically with 114 in Figure 2, to obtain a particular effect, for example polymerization, crosslinking or the like. The station 114 can be a station for treatment with UV radiations, plasma, electron gun or the like. In one embodiment, the station 114 can be positioned downstream of the metallization area above the sources 33, rather than upstream thereof, or two or more stations can be provided both upstream and downstream. When the station 114 is positioned downstream of the vaporization sources, the liquid applicator will also be positioned downstream of these sources.

As a rule, the rollers 53 and 57 can both be made to rotate by a motorized system, for example by motors separate from each other and separate from the main motor that provides the motion to the process roller 19. Separate is intended as additional motors or servomotors with respect to the main motor, which may not be connected mechanically thereto, but possibly with electronic connection, in the sense that the various motors or servomotors are synchronized so that they can operate correctly together.

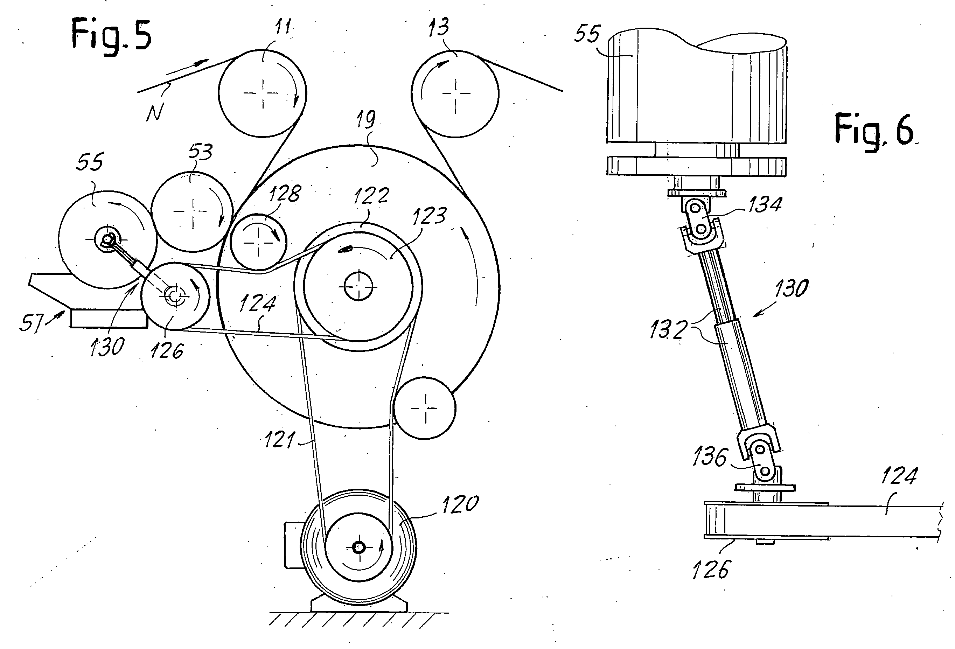

Nonetheless, the movement is preferably transmitted to the anilox or distributor cylinder 55 through a mechanical transmission that takes its motion from the same motor that makes the process roller 19 rotate. Figures 5 and 6 show a particularly advantageous embodiment of this type of transmission. The number 120 schematically indicates a motor that controls rotation of the process roller 19. In one embodiment, the motor can be aligned with the roller 19. Nonetheless, as in the example shown, the motor 120 is preferably positioned out of alignment with respect to the process roller 19, for example under the axis of the process roller 19, and transmits motion to this through a belt 121 and a pulley 123.

In one embodiment, a pulley 122 coaxial with the process roller 19 and with the pulley 123 receives motion from the same motor 120. A toothed belt 124 is fed around the pulley 122. The toothed belt 124 transmits motion to a second toothed pulley 126 and is maintained in tension by a tightening pulley 128. As shown in particular in Figure 6, a telescoping double universal joint, indicated as a whole with 130, is constrained to the pulley 126. The telescoping shaft is indicated with 132 and the two universal joints with 134 and 136 which, thus combined, form a constant velocity joint that transmits motion from the pulley 126 to the distributor cylinder or anilox cylinder 55.

This kinematic drive is particularly advantageous as in the first place it is very simple from the constructional viewpoint and is easy to handle, as it does not require the control of separate motors for the cylinder 55. In the second place, the telescoping shaft 132 and the double universal joint 134, 136 allow the cylinder 55 to be moved with respect to the pulley 126, for example in the case in which it is necessary to change the diameter of the printing cylinder 53.

In a possible embodiment, the printing cylinder 53 is supported idle and made to rotate by simple friction with the anilox cylinder 55 and the process roller 19. This again allows the printing cylinder 53 to be replaced with another printing cylinder of different dimensions without requiring to modify the transmission of motion.

It is understood that the drawing only shows an embodiment of the invention, which can vary in forms and arrangement without however departing from the scope of the concept underling the invention. Any reference numbers in the claims below are provided for the sole purpose of facilitating reading in the light of the description and of the accompanying drawings and do not in any manner limit the scope of protection defined by the claims

## Claims

1. A system for vacuum deposition of a coating on a web material (N), comprising: an evacuable chamber; in said chamber a feed path of the web material in a vacuum environment; along said feed path, a process roller (19) around which said web material is guided; associated with said process roller, at least one vaporization source (31) of at least a first material to form said coating; upstream of said at least one source, along the feed path of the web material, an applicator unit (51) to apply a liquid product to the web material according to a pre-established pattern, said applicator unit comprising a printing cylinder (53), cooperating with a distributor cylinder (55) of said liquid product, and a source (57) of said liquid product; wherein said printing cylinder (53) comprises a liquid-applying discontinuous and non-annular pattern, which gives raise to a cyclical variation of the overall contact surface between said printing cylinder and said web material, and wherein at least one substantially continuous circumferential projection is provided on said printing cylinder, which generates a continuous contact with the web material fed around the process roller (19) or with said process roller during treatment of the web material, such that a continuous contact between the printing cylinder and the web material is obtained during rotation of said printing cylinder and said process roller.

2. System as claimed in claim 1, **characterized in that** said liquid product is an adhesion-preventing product.

3. System as claimed in claim 1 or 2, **characterized in that** said source of said liquid product is an evaporator.

4. System as claimed in claim 1 or 2, **characterized in that** said liquid product source comprises an immersion system.

5. System as claimed in one or more of the previous claims, **characterized in that** said liquid product is an oil.

6. System as claimed in one or more of the previous claims, **characterized in that** said printing cylinder comprises two substantially continuous circumferential projections.

7. System as claimed in claim 5, **characterized in that** said two circumferential projections are arranged in proximity to the ends of the printing cylinder.

8. System as claimed in claim 6, **characterized in that** said printing cylinder comprises one or more substantially continuous intermediate circumferential projections.

9. System as claimed in one or more of the previous claims, **characterized in that** at least one of said printing cylinder and distributor cylinder comprises a temperature control device.

10. System as claimed in claim 9, **characterized in that** the temperature of said printing cylinder is controlled.

11. System as claimed in claim 9 or 10, **characterized in that** the temperature of said distributor cylinder is controlled.

12. System as claimed in one or more of claims 9 to 11, **characterized in that** the temperature of said printing cylinder and/or said distributor cylinder are thermostated and maintained at a controlled temperature.

13. System as claimed in one or more of claims 9 to 12, **characterized in that** said printing cylinder and/or said distributor cylinder are cooled.

14. System as claimed in claim 13, **characterized in that** said printing cylinder and/or said distributor cylinder are cooled through a general water cooling circuit of said system.

15. System as claimed in one or more of claims 9 to 13, **characterized in that** said process roller and said printing cylinder and/or said distributor cylinder are cooled through a common refrigerating circuit.

16. System as claimed in one or more of claims 9 to 13 **characterized in that** said printing cylinder and/or said distributor cylinder are cooled through a refrigerating circuit of their own.

17. System as claimed in one or more of claims 9 to 16, **characterized in that** around said process roller there is disposed at least one treatment station, to treat the liquid product applied by said applicator unit.

18. System as claimed in claim 17, **characterized in that** the treatment station comprises a treatment system that supplies an input of energy to said liquid product to cause crosslinking or polymerization.

19. System as claimed in one or more of the previous claims, **characterized in that** said process roller is made to rotate by a motor and **in that** a mechanical transmission transmits the motion of said motor also to said distributor cylinder.

20. System as claimed in claim 19, **characterized in that** said mechanical transmission is chosen from the group comprising: a gear transmission, a toothed belt transmission, a chain transmission, a shaft transmission, or a combination thereof.

21. System as claimed in claim 19 or 20, **characterized in that** said printing cylinder is mounted idle and made to rotate through contact by said distributor cylinder and/or by said process roller.

22. System as claimed in claim 19, 20 or 21, **characterized in that** it comprises a transmission with a flexible member from a drive pulley, which takes its motion from the motor of the process roller, to a driven pulley, and in which a jointed telescoping shaft connects said driven pulley to the shaft of the distributor cylinder of said applicator unit.

23. A system for vacuum deposition of a coating on a web material (N), comprising: an evacuable chamber; in said chamber a feed path of the web material in a vacuum environment; along said feed path, a process roller (19) around which said web material is guided; along the feed path of the web material, an applicator unit (51) to apply a liquid product to the web material according to a pre-established pattern, said applicator unit comprising a printing cylinder (53), cooperating with a distributor cylinder (55) of said liquid product, and a source (57) of said liquid product, **characterized in that** at least one of said printing cylinder and said distributor cylinder is maintained at a controlled temperature.

24. System as claimed in claim 23, **characterized in that** at least one of said printing cylinder and said distributor cylinder is cooled.

25. System as claimed in claim 23 or 24, **characterized in that** said process roller is cooled.

26. System as claimed in claim 23, 24 or 25, **characterized in that** it comprises, associated with said process roller, at least one vaporization source (31) of at least a first material to form said coating.

27. System as claimed in one or more of claims 23 to 26, **characterized in that** around said process roller there is disposed at least one treatment station, to treat the liquid product applied by said applicator unit.

28. System as claimed in claim 27, **characterized in that** said treatment station comprises a system to supply an input of energy to said liquid and cause a crosslinking or a polymerization thereof.
